# EUROPEAN PATENT SPECIFICATION

(11) **EP 4 199 111 B1**
(45) Date of publication and mention of the grant of the patent: **24.06.2026**
(21) Application number: 21214869.6
(22) Date of filing: 15.12.2021
(51) Int. Cl.: H10D 30/01, H10D 30/67, H10D 62/10, H10D 64/01, H10D 84/01, H10D 84/02, H10D 84/03, H10D 84/85, B82Y 10/00

(54) **A METHOD FOR FORMING A PRECURSOR SEMICONDUCTOR DEVICE STRUCTURE**
VERFAHREN ZUR HERSTELLUNG EINER VORLÄUFER-HALBLEITERBAUELEMENTSTRUKTUR
PROCÉDÉ DE FORMATION D'UNE STRUCTURE DE PRÉCURSEUR DE DISPOSITIF À SEMI-CONDUCTEUR

(43) Date of publication of application: 21.06.2023
(73) Proprietor: Imec VZW, 3001 Leuven (BE)
(72) Inventor: Subramanian, Sujith, 3000 Leuven (BE); Demuynck, Steven, 3200 Aarschot (BE); Mertens, Hans, 3000 Leuven (BE)
(74) Representative: AWA Sweden AB

(56) References cited:
- WO-A1-2021/232916
- US-A1- 2017 213 911
- US-A1- 2019 319 119
- US-A1- 2020 273 753
- US-A1- 2021 193 797

## Description

### Technical field

The present disclosure relates to a method for forming a precursor semiconductor device structure, and a method for forming a semiconductor device.

### Background

The constant strive to achieve ever more area- and power-efficient circuits has resulted in development of horizontal channel transistor devices with a 3D geometry, based on stacks of nanowires or nanosheets, such as nanowire field-effect transistors (NWFET) and nanosheet FETs (NSHFET) including one or more nanowire- or nanosheet-shaped channel layers and a "wrap-around" gate surrounding the channel layers completely or at least partly. Further examples are the forksheet device and the Complementary FET (CFET).

Current fabrication processes for such devices may typically involve processing of a semiconductor layer stack of alternatingly channel layers of Si and sacrificial layers of SiGe. Etching processes have been developed which allow for SiGe to be etched with a relatively high selectively to Si, such that the sacrificial layers may be removed selectively to the channel layers. For example, wrap-around gates may be formed by removing sacrificial layer material above and below the channel layers to form "released" channel layers (e.g. in connection with a replacement metal gate process), to subsequently be surrounded by the gate stack.

US 2017/213911 A1 is a document that describes a semiconductor structure which includes a plurality of stacked and suspended semiconductor nanosheets. A functional gate structure is located around the plurality of stacked and suspended semiconductor nanosheets. According to US 2017/213911 A1, an initial material stack comprising a sacrificial semiconductor layer and a semiconductor channel layer is formed on a substrate. The stack is then patterned, and a sacrificial gate structure is formed. Subsequently, each sacrificial semiconductor layer is replaced with a dielectric material, such as a flowable oxide. The resulting structure can be used as a precursor for subsequent device manufacturing.

US 2020/273753 A1 is a document that describes forming vertical fins in a semiconductor layer stack and forming a sacrificial epitaxial layer over the substrate surrounding the vertical fins.

US 2019/319119 A1 discloses a precursor structure comprising a stack formed on a substrate by epitaxially growing alternating dielectric layers and semiconductor layers.

### Summary

Combining layers of Si and SiGe in a layer stack is however not without issues. The presence of SiGe may require a lowering of the thermal budget for the fabrication process, e.g. to avoid intermixing of the Si- and SiGe-layers and/or defect formation in the SiGe-layers. Among others, a lower thermal budget may result in a less robust shallow trench isolation (STI) oxide, which in turn may result in a greater loss of STI oxide in subsequent processing stages.

In light of the above, it is an object to provide an improved method for semiconductor device fabrication. In particular, it is an object to provide a method enabling forming of a semiconductor device structure, which may be used as a precursor structure in methods for forming semiconductor devices, comprising e.g. NW- or NSHFETs, without requiring a lowering of the thermal budget. Further and alternative objectives may be understood from the following.

The invention is defined by the claims. There is provided a method for forming a precursor semiconductor device structure according to claim 1, the method comprising:
forming, on a substrate, an initial layer stack comprising a sacrificial layer of a first semiconductor material and, over the sacrificial layer, a channel layer of a second semiconductor material;
forming a set of fin structures by patterning trenches in the initial layer stack, each fin structure comprising a respective sacrificial layer of the first semiconductor material and a respective channel layer of the second semiconductor material;
forming at least one anchoring structure extending across the set of fin structures, and while the channel layers are anchored by the at least one anchoring structure:
   removing the sacrificial layers of each fin structure by a selective etching of the first semiconductor material, thereby forming a longitudinal cavity underneath the channel layer of each fin structure, and
   depositing an insulating material to fill the cavities, wherein the insulating material is formed of a flowable dielectric; and
subsequently recessing the at least one anchoring structure and the insulating material to a level below the cavities such that the insulating material remains in the cavities to form insulating layers underneath the channel layers of each fin structure.

By the method, sacrificial layers of the first semiconductor material may be replaced by insulating layers of the insulating material. Thereby, a precursor semiconductor device structure may be formed comprising fin structures, each comprising a respective insulating layer and a channel layer over the insulating layer. The insulating layers of the fin structures may facilitate a selective processing of the insulating layers and semiconductor channel layers, for instance selective removal and etching of the insulating material for the purpose of channel release. However, the insulating layers may additionally function as a bottom isolation underneath the channels, enabling reduced leakage currents and improved device performance.

For instance, the sacrificial layers may be formed of SiGe (e.g. SiGe_{y≥0.15}) and the channel layers may be formed of Si, wherein the sacrificial layers may be removed selectively to the channel layers and replaced by insulating layers. The resulting fin structures may thereby be more thermally stable and thus facilitate fabrication of semiconductor devices, e.g. NW- or NSHFETs, without requiring a reduced thermal budget. This may enable a more robust STI oxide and in turn contribute to improved process margins in various steps in a CMOS semiconductor fabrication flow in terms of STI loss.

Although applying the method to layer stacks comprising SiGe sacrificial layers and Si channel layers is one notable application of the method, it is contemplated that the method may have further applicability, and may be used in any context where it may be advantageous to provide an insulating layer underneath a channel layer. As one example, the first semiconductor material may be SiGe_{y} and the second semiconductor material may be SiGeₓ, where 0 ≤ x < y, e.g. y ≥ x + 0.15. The method may hence be used to replace a SiGe-sacrificial layer with a higher Ge-content than a Si- or SiGe-channel layer, by an insulating layer. Corresponding advantages may thus be obtained, e.g. as the resulting fin structures may be less sensitive to thermally driven inter-mixing of the SiGeₓ and SiGe_{y} layers.

The at least one anchoring structure allows the channel layers to be anchored and thus supported above the cavities formed in the respective fin structures by removing the sacrificial layers. As the sacrificial layers are removed from the fin structures (i.e. completely), each cavity may be formed to be coextensive with the respective fin structure and the channel layer thereof (as seen along a longitudinal dimension of the fin structure). This applies correspondingly to the insulting layers.

Depositing the insulating material in the form of a flowable dielectric enables reliable and void-free filling also of cavities of relatively great longitudinal dimensions and narrow cross-sectional dimensions. The insulating material may for example be a flowable oxide, e.g. a flowable-Chemical Vapor Deposition (FCVD) oxide such as FCVD SiO₂.

As used herein, the wording "precursor semiconductor device structure" is to be understood as a semiconductor device structure which may be used as a precursor or an intermediate product in a method for forming a semiconductor device, wherein the precursor semiconductor device structure may be subjected to device processing steps to form a semiconductor device.

Accordingly, according to an aspect, there is provided a method for forming a semiconductor device, the method comprising: forming a precursor semiconductor device structure in accordance with the above or any of the embodiments or variations thereof described herein; and subsequently, along one or more of the fin structures of the precursor semiconductor device structure, forming a gate structure and source and drain regions.

One or more transistor devices, such as FET devices, may accordingly be formed along one or more of the fin structures. It is contemplated that the preliminary semiconductor device structure advantageously may be used to facilitate forming of NW- or NSHFETs, as well as stacked transistor device structures such as the complementary FET (CFET) device.

Embodiments of methods for forming the precursor semiconductor structure will be described hereinafter:
In some embodiments, the channel layer may be a second channel layer and the initial layer stack and each fin structure may further comprise a first channel layer of the second semiconductor material, wherein the sacrificial layer is formed on the first channel layer and the second channel layer is formed on the sacrificial layer.

The initial layer stack and each fin structure may accordingly comprise (e.g. in a bottom-up direction) a first channel layer of the second semiconductor material, a sacrificial layer of the first sacrificial layer and a second channel layer of the second semiconductor material. By replacing the sacrificial layer of each fin structure with an insulating layer in accordance with the method, fin structures comprising the first and the second channel layers separated by an insulating layer may hence be formed. The insulating layer may be used as a sacrificial layer in a method for forming a semiconductor device to facilitate forming of a gate stack between the channel layers. The insulating layer may also be used as an insulating layer to electrically separate the bottom device from the top device in a CFET device.

The sacrificial layer may further be a second sacrificial layer and the initial layer stack and each fin structure may further comprise a first sacrificial layer of the first semiconductor material, wherein the first channel layer is formed on the first sacrificial layer. The initial layer stack and each fin structure may accordingly comprise (e.g. in a bottom-up direction) a first sacrificial layer of the first semiconductor material, a first channel layer of the second semiconductor material, a second sacrificial layer of the first sacrificial layer and a second channel layer of the second semiconductor material. By replacing the first and second sacrificial layers of each fin structure with an insulating layer in accordance with the method, fin structures comprising a first insulating layer, the first channel layer, a second insulating layer, and the second channel layer may be formed. The insulating layers may be used as sacrificial layers in a method for forming a semiconductor device to facilitate forming of a gate stack completely surrounding the first channel layer.

In some embodiments, the layer stacks and fin structures may each comprise a plurality of sacrificial layers of the first semiconductor material and a plurality of channel layers of the second semiconductor material, wherein the channel layers are arranged alternatingly with the sacrificial layers (e.g. in a bottom-up direction). This allows forming of semiconductor devices comprising plural channel layers.

According to the invention, forming comprises the at least one anchoring structure depositing an anchoring material layer structure of one or more layers on the set of fin structures and in the trenches, and patterning the anchoring material layer structure to form the at least one anchoring structure.

An anchoring material layer structure may hence be formed in contact (i.e. in abutment with) with each fin structure and subsequently be patterned to form at least one anchoring structure at desired locations along the fin structures.

In some embodiments, patterning the anchoring material layer structure may comprise forming at least one mask line extending across the set of fin structures and etching the anchoring material layer structure using the at least one mask line as an etch mask such that fin structure side surface portions not masked by the at least one mask line are exposed,
wherein removing the sacrificial layers comprises etching the first semiconductor material from the exposed side surface portions of each fin structure, and
wherein depositing the insulating material comprises depositing the insulating material such that the trenches between the fin structures and the cavities are filled with the insulating material.

The at least one anchoring structure may hence be formed to allow access to side surface portions of each fin structure. The etching of the sacrificial layers and the deposition of the insulating material may hence be performed from the sides of the fin structure, which may facilitate removal of the sacrificial layers as well as the filling of the cavities.

The number of mask lines may be varied to form a number of anchoring structures sufficient for securely anchoring the channel layers. For example, first and second parallel mask lines may be formed across the set of fin structures, at opposite ends thereof. A first and second anchoring structure extending across the set of fin structures may thus be formed at the opposite ends of the set of fin structures. The channel layers may hence be supported by the anchoring structure, at least at opposite ends of the fin structures. In another example, a plurality of parallel and regularly spaced apart mask lines may be formed across the set of fin structures. A plurality of parallel and regularly spaced apart anchoring structures extending across the set of fin structures may thus be formed with a regular spacing along the set of fin structures. Plural anchoring structures may enable a mechanically reliable anchoring of the channel layers.

According to the invention, the anchoring material layer structure comprises an insulating fill layer deposited to fill the trenches.

The insulating fill layer may accordingly embed the fin structures. This enables forming one or more anchoring structures along a full height of the fin structures may hence be formed, i.e. "tall" anchoring structures. A tall anchoring structure may provide a secure anchoring function. Each anchoring structure may for example comprise a plurality of (tall) anchoring parts, each anchoring part bridging a trench between a neighboring pair of fin structures. As the fill layer is insulating, if thickness portions of the insulating fill layer remain after recessing the at least one anchoring structure (intentionally or as trace amounts), such portions may have little or no impact on the performance of the final device.

The recessing of the at least one anchoring structure and the insulating material may comprise simultaneously recessing the insulating fill layer and the insulating material to the level below the cavities. The level to which the recess proceeds may be such that a thickness portion of the insulating fill layer and the insulating material remains to form STI in a bottom part of the trenches.

A simultaneous recess may reduce a complexity of the process. Furthermore, preserving a thickness portion of the insulating fill layer and the insulating material as STI in the trenches, between the fin structures, obviates the need for a separate STI deposition step. The fill layer and the insulating layer may hence each provide a double-function of forming the at least one anchoring structure and forming the STI, and forming the insulating layers replacing the sacrificial layers and forming the STI, respectively.

In some embodiments representing alternatives to the embodiments comprising patterning using one or more mask lines, the method may further comprise forming a fin cut mask over the anchoring material layer structure, wherein patterning the anchoring material layer structure may comprise etching the anchoring material layer structure using the fin cut mask as an etch mask, wherein the patterned anchoring material layer structure may form part of the anchoring structure.

The method may further comprise, subsequent to patterning the anchoring material layer structure, removing parts of each fin structure by etching the fin structures using the fin cut mask as an etch mask, thereby forming a set of cut fin structures covered by the anchoring structure and having exposed end surfaces.

Removing the sacrificial layers may accordingly comprise etching the first semiconductor material from the end surfaces of each fin structure.

Additionally, the deposition of the insulating material may be performed from openings of the cavities formed at the end surfaces portions of each fin structure.

The sacrificial layer replacement may hence be combined with a fin cut process.

A single anchoring structure coextensive with the (cut) fin structures may hence be formed across the set of fin structures. The anchoring structure may hence support the channel layers along the full longitudinal dimension of the fin structures, thus enabling a mechanically reliable anchoring of the channel layers.

The fin cut mask may be removed subsequent to forming the set of cut fin structures, at least prior to depositing the insulating material, such as prior to removing the sacrificial layers to form the cavities.

The anchoring material layer structure may comprise an insulating fill layer deposited to fill the trenches.

The insulating fill layer may accordingly embed the fin structures. This enables forming of the anchoring structure along the full height and full length of the fin structures, i.e. "tall" and "long" anchoring structures.

A tall and long anchoring structure may provide a secure anchoring function. The anchoring structure may for example comprise a plurality of (e.g. tall and long) anchoring parts, each anchoring part bridging and being coextensive with (i.e. filling) a trench between a neighboring pair of fin structures. As the fill layer is insulating, if thickness portions of the insulating fill layer remain after recessing the anchoring structure (intentionally or as trace amounts), such portions may have little or no impact on the performance of the final device.

The recessing of the anchoring structure and the insulating material may comprises simultaneously recessing the insulating fill layer and the insulating material to the level below the cavities, wherein the level is such that a thickness portion of the insulating fill layer remains to form STI in a bottom part of the trenches.

A simultaneous recess may reduce a complexity of the process. Furthermore, preserving a thickness portion of the insulating fill layer as STI in the trenches, between the fin structures, obviates the need for a separate STI deposition step. The fill layer may hence provide a double-function of forming the at least one anchoring structure and forming the STI.

In embodiments comprising patterning using one or more mask lines , and embodiments comprising patterning using a fin cut mask alike, the insulating fill layer may be formed of a same material as the insulating material, i.e. the flowable dielectric, e.g. a flowable oxide such as FCVD SiO₂.

The insulating fill layer may be formed in direct contact, i.e. in abutment with, the side surfaces of the fin structures and bottom surface of the trenches. This enables an anchoring structure of a single material composition, which may facilitate the patterning and avoid the need of additional etching steps during the recessing.

Alternatively or additionally, the anchoring material layer structure may comprise an insulating liner layer conformally deposited on the fin structures and in the trenches. A conformally deposited layer, e.g. deposited by atomic layer deposition (ALD) enables forming anchoring structures with precise thickness control and good adhesion to the fin structures, e.g. the side surfaces thereof. Similar to the discussion of the fill layer, as the liner layer is insulating, if portions of the insulating fill layer remain after recessing the at least one anchoring structure (intentionally or as trace amounts), such portions may have little or no impact on the performance of the final device.

The insulating liner layer may further be combined with the insulating fill layer, by depositing the insulating fill layer on the liner layer, thereby providing a combination of the respective advantages discussed above.

The recessing of the at least one anchoring structure may further comprise removing portions of the liner layer present above said level by etching. That is, the recessing may comprise first recessing the insulating material and the insulating fill layer (if present) to said level below the cavities, and thereafter recessing liner layer to said level by removing portions of the liner layer present above said level by etching.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1a-b to 9a-b illustrate an embodiment of a method for forming a semiconductor device structure.
Figures 10a-b and 11a-c to 14a-c illustrate an alternative embodiment of a method for forming a semiconductor device structure.
Figure 15 is a flow chart of a method for forming a semiconductor device.

### Detailed description

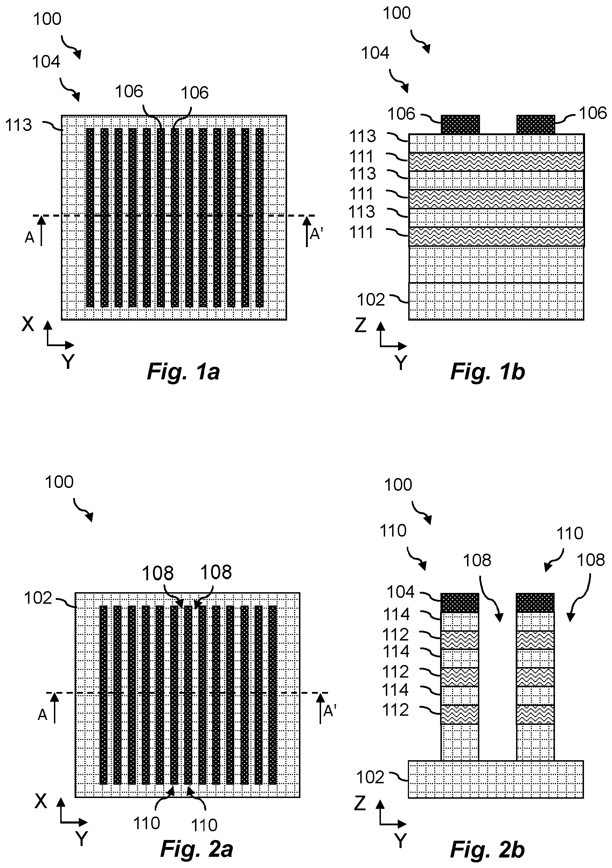

A method for forming a semiconductor device structure 100 will now be described with reference to Figs. 1a-b to 9a-b. It should be noted that in the figures, the relative dimensions of the shown elements, in particular the relative thickness of the layers, is merely schematic and may differ from a physical structure in order to facilitate understanding of different aspects of the method. The structure 100 is suitable for use as a precursor structure or an intermediate product to a method for forming a semiconductor device, e.g. a NW- or NSHFET, a forksheet device, or a CFET device.

In the figures, axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 102 of the structure 100. The Z-direction is parallel to a normal direction to the substrate 102.

Fig. 1a is a top-view of the structure 100. Fig. 1b is a cross-sectional view of the structure 100 taken along the vertical plane A-A' (parallel to the YZ-plane). The views of the subsequent figures correspond to those in Figs. 1a-b unless stated otherwise.

Figs. 1a-b show an initial layer stack 104 formed on a substrate 102 and comprising a number of sacrificial layers 111 and a number of channel layers 113 arranged alternatingly with the sacrificial layers 111. The substrate 102 may be a conventional semiconductor substrate suitable for complementary FETs. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The number of sacrificial and channel layers 111, 113 shown in the figures is merely one example and an initial layer stack comprising fewer or greater numbers of sacrificial and channel layers is also possible. In one example, an initial layer stack may comprise a single sacrificial layer and a single channel layer on the sacrificial layer. In another example, an initial layer stack may comprise a bottom sub-stack of alternating sacrificial and channel layers, a top sub-stack of alternating sacrificial and channel layers, and an intermediate sacrificial layer separating the lower and upper sub-stacks. Such a layer composition may be suitable for a CFET device, wherein a bottom device may be formed at the bottom sub-stack and a top device may be formed at the top sub-stack. As may be appreciated from the following, the intermediate sacrificial layer may be replaced with an insulating layer to provide electrical and physical separation between the bottom and top devices. The intermediate sacrificial layer may be thicker than the sacrificial layers of the bottom and top sub-stacks to enable an increased device separation.

The sacrificial layers 111 are formed of a first semiconductor material. The channel layers 113 are formed of a second semiconductor material. For example, the first and second semiconductor materials may be Si_{1-y}Ge_{y} and Si₁₋ₓGeₓ respectively, wherein 0 ≤ x < y. For example, y may be equal to or greater than x + d, where d ≥ 0.15. In a more specific example, the first semiconductor material may be SiGe_{0.15} and the second semiconductor material may be a Si. These relative differences in Ge-content may facilitate subsequent selective processing (e.g. selective etching) of the first semiconductor material and the second semiconductor material.

The layers of the device layer stack 104 may each be epitaxial layers, e.g. epitaxially grown using deposition techniques which per se are known, such as chemical vapor deposition (CVD) or physical vapor deposition (PVD). This enables high quality material layers with an advantageous degree of control of composition and dimensions.

In another example of an initial layer stack, a further sacrificial layer of a third semiconductor material (different from the first and second semiconductor materials) may be present between a sacrificial layer of the first semiconductor material and a channel layer of the second semiconductor material. The third semiconductor material may for example be a layer of SiGe with Ge content less than the first semiconductor material and greater than the second semiconductor material. This may allow the further sacrificial layer to be replaced with a different insulating material than the insulating material replacing the sacrificial layer of the first semiconductor material.

After forming the initial layer stack 104, a hard mask 106 may be formed over the initial layer stack 104. The hard mask 106 may comprise one or more layers of hard mask material (e.g. oxide- or nitride-based hard mask material) and be patterned to form a set of parallel and regularly spaced line features, extending along the X-direction. The hard mask 106 is to be used for a subsequent step of fin patterning, as will be described below, and may be patterned using any suitable conventional patterning technique, such as lithography and etching ("litho-etch") or multiple-patterning techniques such as (litho-etch)^{x}, self-aligned double or quadruple patterning (SADP or SAQP).

In Figs. 2a-b, a set of elongated and fin-shaped layer structures 110 (i.e. "fin structures") have been formed by patterning trenches 108 in the initial layer stack 104, by etching the initial layer stack 104 while using the hard mask 106 as an etch mask. Any suitable wet or dry wet etching process may be used, e.g. a top-down anisotropic etch. The fin structures 110 extend along the X-direction and are separated by the trenches 108. Each fin structure 110 comprises a number of respective sacrificial layers 112 of the first semiconductor material and a respective number of channel layers 114 of the second semiconductor material. The trenches 108 may as shown be etched to extend through each sacrificial layer 111 and each channel layer 113 such that fin structures 110 comprising a corresponding number of sacrificial layers 112 and channel layer 114 may be formed. The trenches 108 may as shown further extend into an upper thickness portion of the substrate 102, however it is also possible to stop the etching on the substrate 102. The layers of the layer stack 110 may each be formed as nanosheets, e.g. with a width (along Y) to thickness (along Z) ratio greater than 1, such as a width in a range from 10 nm to 30 nm and a thickness in a range from 3 nm to 10 nm. It is also possible to pattern the layer stack 110 such that the layers form nanowire-shaped layers. A nanowire may by way of example have a thickness similar to the example nanosheet however with a smaller width, such as 3 nm to 10 nm.

In the illustrated example, the hard mask 106 is preserved on the fin structures 110 during the subsequent processing, however it is envisaged that the hard mask 106 also may be removed after forming the fin structures 110.

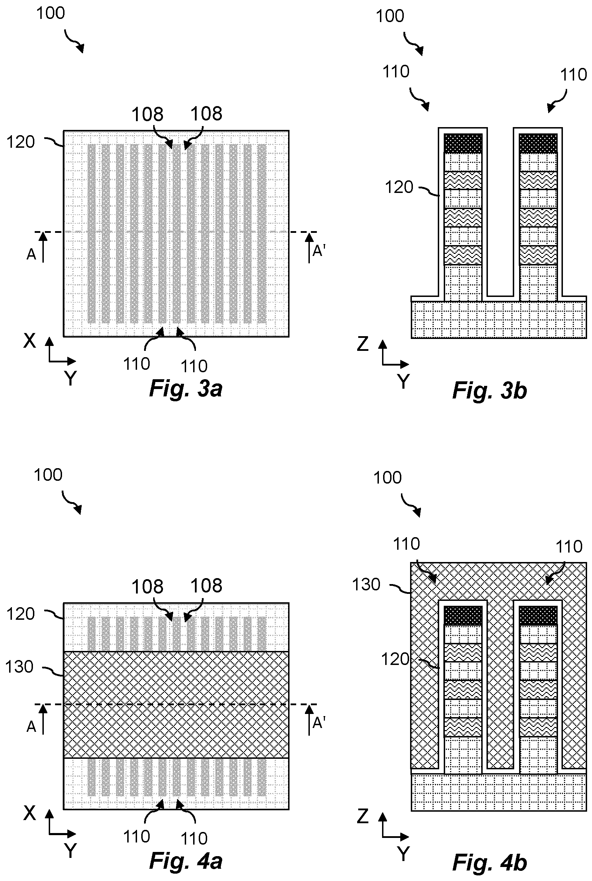

In Figs. 3a-b an insulating liner layer 120 has been conformally deposited over the structure 100, e.g. on the fin structures 110 and in the trenches 108. The liner layer 120 is hence formed to cover side surfaces of the fin structures 110, the hard mask 106 and a bottom surface of the trenches 108. The liner layer 120 may be formed of a nitride, such as SiN, however other conformally deposited dielectric materials are also possible such as SiCO, SiCBN or SiCON. The liner layer 120 may be deposited by ALD. It is also possible to form the liner layer 120 as e.g. a pair of conformally and sequentially deposited layers of different insulating materials. The liner layer 120 may by way of example be formed with a thickness in a range of 1-10 nm, but the thickness may be varied depending on the layer composition, the dimensions and spacing of the fin structures 110. In Fig. 3a, the liner layer 120 is depicted as partly transparent to allow a view of the fin structures 110 and trenches 108.

In Figs. 4a-b a fin cut mask 130 has been formed over the liner layer 120. The fin cut mask 130 extends across the fin structures 110 along the Y-direction. A indicated by the label "fin cut mask", the fin cut mask 130 is to be used as an etch mask during a subsequent "fin cut process" and may accordingly comprise one or more mask materials allowing the fin cut mask 130 to withstand the etching processes of the fin cut process. The fin cut mask may for example comprise a spin-on-carbon or another organic spin-on material formed to fill the trenches 108 and provide a planar upper surface. Additionally or alternatively the fin cut mask may comprise a layer of amorphous silicon. After deposition, the fin cut mask materials may be subjected to a patterning step to define the fin cut mask 130 with the desired extension in the XY-plane.

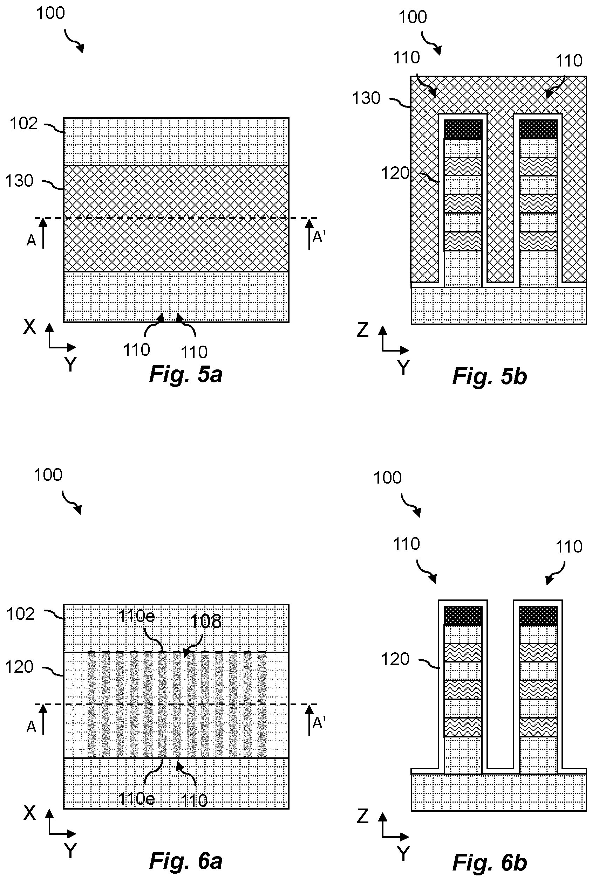

In Figs. 5a-b, the liner layer 120, and subsequently the fin structures 110 have been etched while using the fin cut mask 130 as an etch mask. Parts of the liner layer 120 not covered by the fin cut mask 110, and parts of the fin structures 110 underneath, have thus been removed. The remaining parts of the fin structures 110 may be referred to as a set of cut fin structures.

As shown in Figs 6a-b, the fin cut mask 130 has subsequently been removed. As a result of the cutting of the fin structures, the cut fin structures 110 have end surfaces 110e exposed at opposite ends of the cut fin structures 110.

The (patterned) liner layer 120 defines an anchoring structure extending across the cut fin structures 110 along the Y-direction and being coextensive with the longitudinal dimension of the cut fin structures 110, i.e. along the X-direction. The label "cut" may in the following be omitted for conciseness.

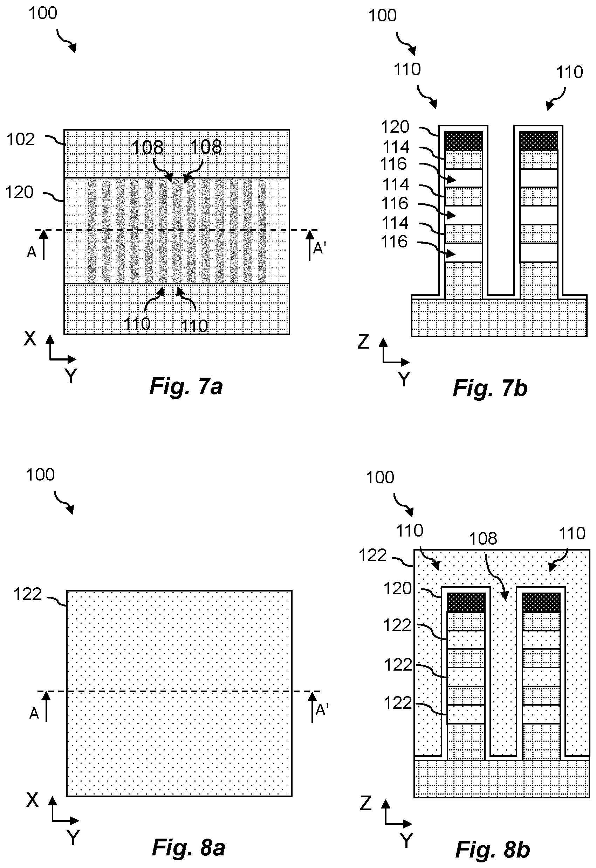

In Fig. 7a-b the sacrificial layers 112 of each fin structure 110 have been removed by a selective etching of the first semiconductor material (i.e. etching the first semiconductor material selectively to the second semiconductor material) from the opposite end surfaces 110e of each fin structure 110. A longitudinal cavity 116 has thus been formed underneath each channel layer 114 of each fin structure 110. During the removal the channel layers 114 are anchored by the anchoring structure defined by the liner layer 120. An isotropic etching process, wet or dry, may be used to remove the sacrificial layers 112. For example, a sacrificial layer 112 of SiGe with a greater concentration of Ge than a channel layer 114 of Si or SiGe may be etched selectively (i.e. at a greater rate) using an HCl-based dry etch may be used. A further example is ammonia peroxide mixture (APM). However, other appropriate etching processes (wet or dry) allowing selective etching of higher Ge-content SiGe layers with respect to lower Ge-content SiGe (or Si) layers are per se known in the art and may also be employed for this purpose.

In Figs. 8a-b, an insulating material 122 formed by a flowable dielectric has been deposited such that the trenches 108 and the cavities 116 are filled the insulating material. Similar to the removal of the sacrificial layers 112, the insulating material 122 may be deposited in the cavities 116 from open ends thereof at the end surfaces 110e of the fin structures 110.

Depositing the insulating material 122 in the form of a flowable dielectric enables reliable and void-free filling of the trenches 108 and the cavities 116. The insulating material may for example be a flowable oxide, e.g. a FCVD oxide such as FCVD SiO₂. However other types of flowable dielectrics suitable to provide insulation underneath and between the channel layers 114 are also possible. As per se is known in the art, deposition of a flowable dielectric may comprise a number of sub-steps such as introducing a number of gas-phase precursor to deposit a flowable dielectric film with a flowable (i.e. fluid) appearance, such that the flowable dielectric film may flow into the trenches 108 and into the cavities 116. The flowable film may subsequently be subjected to post-processing steps to solidify the film (e.g. annealing or and/or subjecting the film to an oxidizing plasma) and form a solid (i.e. non-fluid) insulating layer 122. After deposition, the insulating material 122 may if needed be planarized, e.g. by chemical mechanical polishing (CMP). Optionally, the deposition of the insulating material 122 may be preceded by a conformal deposition of a further insulating material, such that exposed surfaces of each fin structure 110 (e.g. lower and/or upper surfaces of the channel layers 114 exposed in the cavities 116) are covered by the further insulating material. The further insulating material may for example be a nitride such as SiN, e.g. deposited by ALD. The insulating material 122 may accordingly fill a remaining space of the cavities 116. The conformally deposited layer may mask the semiconductor material of the channel layers 114 from the process conditions during the deposition of the flowable dielectric insulating material 112.

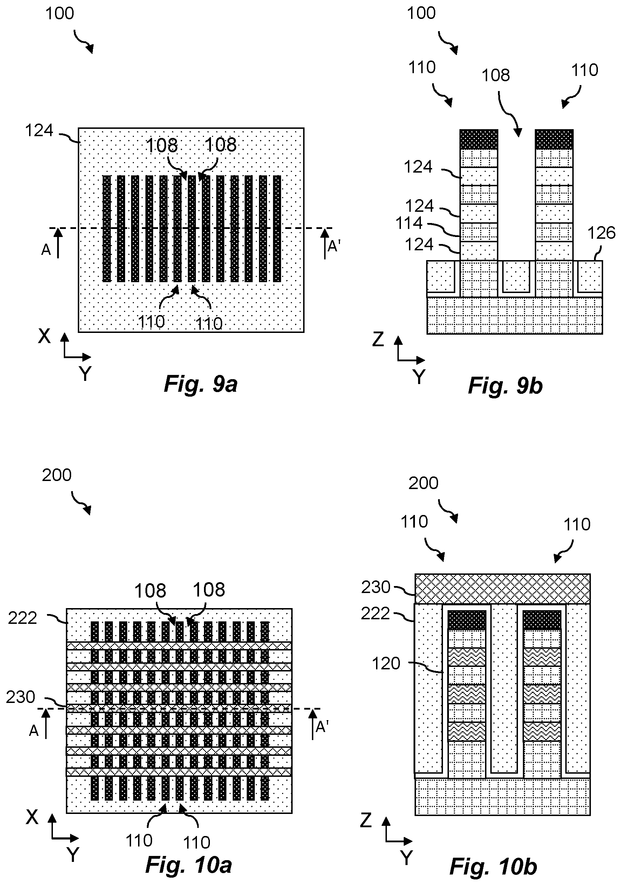

In Figs. 9a-b the anchoring structure / patterned liner layer 120 and the insulating material 122 have been recessed (top-down, e.g. negative Z direction) to a level below a bottom-most one of the cavities 116. As shown, side surfaces of the fin structures 110 may thus exposed and insulating material 122 may remain in the cavities to form insulating layers 124 underneath the channel layers 114. The recessing may comprise etching back the liner layer 120 and the insulating material 122 in a top-down direction (e.g. along the negative Z direction). The recessing may as shown be stopped such that a thickness portion of the insulating material remains to form STI 126 in a bottom part of the trenches 108. The liner layer 120 and the insulating material 122 may be recessed simultaneously, using a common etching process. However, it is also possible to first recess the insulating material 122 and subsequently remove portions of the liner layer 120 exposed above a level of the insulating material 122, to expose the side surfaces of fin structures 110. As shown in Fig. 9b, portions of the liner layer 120 may remain on a bottom portion of the fin structures 110 and hence form part of the STI. If the optional conformally deposited further insulating material is present, this may also be recessed to a same extent.

In the example described above, an anchoring structure coextensive with the fin structures 110 is formed by patterning an anchoring material layer structure of a single liner layer 120, using a fin cut mask 130. In the following, an alternative embodiment will be disclosed with reference to Figs. 10a-b to 14a-b.

Figs. 10a-b depict a semiconductor device structure 200 similar to the structure 100 shown in Figs 2a-b, wherein like reference signs refer to like elements unless stated otherwise. An anchoring material layer structure comprising an insulating layer 120 and a fill layer 222 have been formed on the fin structures 100. The insulating liner layer 120 has been conformally deposited over the structure 100, e.g. on the fin structures 110 and in the trenches 108. The insulating fill layer 222 has subsequently been deposited on the insulating liner layer 120, to fill the trenches 108 and embed the fin structures 100. In the illustrated embodiment, it will be assumed that the fill layer 222 is formed by a flowable dielectric, such as any of the materials exemplified for the insulating layer 122 above, e.g. a FCVD SiO₂. In other embodiments the fill layer 222 may instead be formed of a non-flowable dielectric material, such as CVD- or PVD-deposited SiO₂ or another conventional inter-layer dielectric material. After deposition, the fill layer 222 may if needed be planarized, e.g. by CMP, and further be recessed (top-down, e.g. negative Z direction) such that an upper surface of the fill layer 222 is flush with an upper surface of the liner layer 120 (e.g. on an upper surface of the hard mask 106). The fill layer 222 and the liner layer 120 are depicted as partly transparent to allow a view of the fin structures 110 and trenches 108 underneath.

Additionally, a number of mask lines 230 have been formed over the fin structures 110, the liner layer 120 and the fill layer 222. The mask lines 230 extend in parallel and across the fin structures 100 along the Y-direction. The mask lines 230 may be formed in a manner similar to the hard mask 106, e.g. by depositing and then patterning one or more layers of a mask material (e.g. an organic spin-on-layer, a nitride layer, an oxide layer, a photoresist layer) using single- or multiple-patterning techniques to define a desired number of mask lines 230. In contrast to the fin cut mask 130, the mask lines 230 will not be used to cut the fin structures 110, but merely to pattern the anchoring material layer structure. Fin cutting may for example have been performed using a conventional process prior to the stage depicted in Figs. 10a-b, such that the illustrated fin structures 110 define cut fin structures. In the illustrated embodiment, a plurality of equally spaced mask lines 230 are formed. As may be appreciated from the following, this configuration of mask lines 230 may enable forming a mechanically reliable anchoring structure. However, it is envisaged that other configurations also are possible, such as only a pair of mask lines, e.g. extending across opposite end portions of the fin structures 110, or only a single mask line extending across a central portion of the fin structures 110. The latter example may be useful e.g. when applying the method to relatively short fin structures and/or fin structures comprising relatively thick channel layers such that they can tolerate an increased bending force without collapse during sacrificial layer removal.

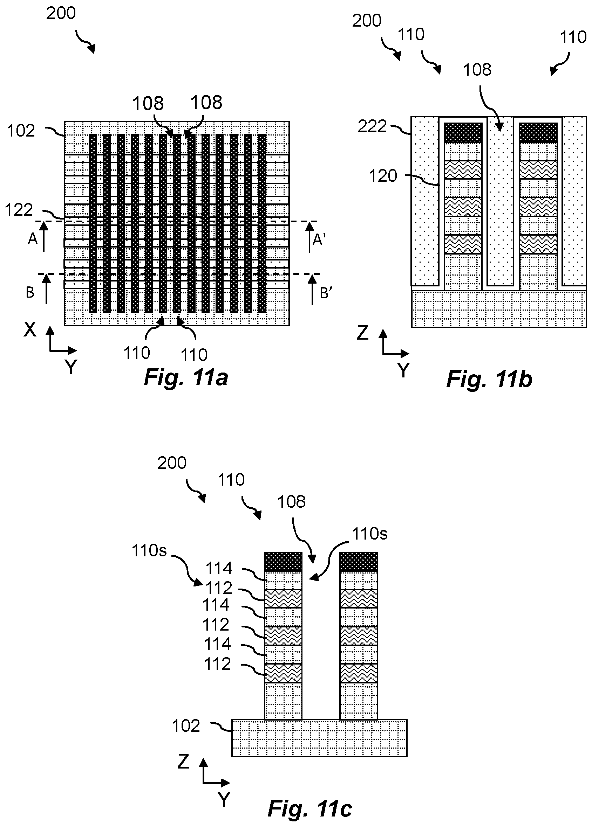

In Figs. 11a-c the anchoring material layer structure formed by the liner layer 120 and fill layer 222 has been patterned by etching while using the mask lines 230 as an etch mask. Fig. 11c is a further cross-sectional view of the structure 200 taken along the vertical plane B-B' (parallel to the YZ-plane). More specifically, the plane B-B' is defined at a position adjacent a mask line 230 (e.g. between a neighboring pair of mask lines 230) such that the cross-sectional view extends through a portion of the fin structures 110 not masked by any mask line 230. Accordingly, as shown in the Fig. 11c the liner layer 120 and fill layer 222 have been etched such that fin structure side surface portions 110s not masked by any mask line 230 are exposed in the trenches 108. Meanwhile, as shown in Fig. 11b, anchoring structures (in a number corresponding to the number of mask lines 230) extending across the set of fin structures 110 are preserved underneath the mask lines 230. Each anchoring structure is formed by a line-shaped portion of the liner layer 120 and a plurality of fill layer portions 222 preserved underneath each respective mask line 230. Each anchoring structure forms a partition extending across (e.g. "bridging") each trench 108 along the Y-direction. Due to the regular spacing of the mask lines 230, the anchoring structures may also be formed with a regular spacing along the set of fin structures 110. Depending on an etch contrast between the fill layer 222 and the liner layer 120, the fill layer 222 and the liner layer 120 may be etched simultaneously using a common etching chemistry, or the fill layer 222 may be etched in a first etch step to expose the portions of the liner layer 120 between the mask lines 230. The portions of the liner layer 120 may subsequently be removed in a second etch step.

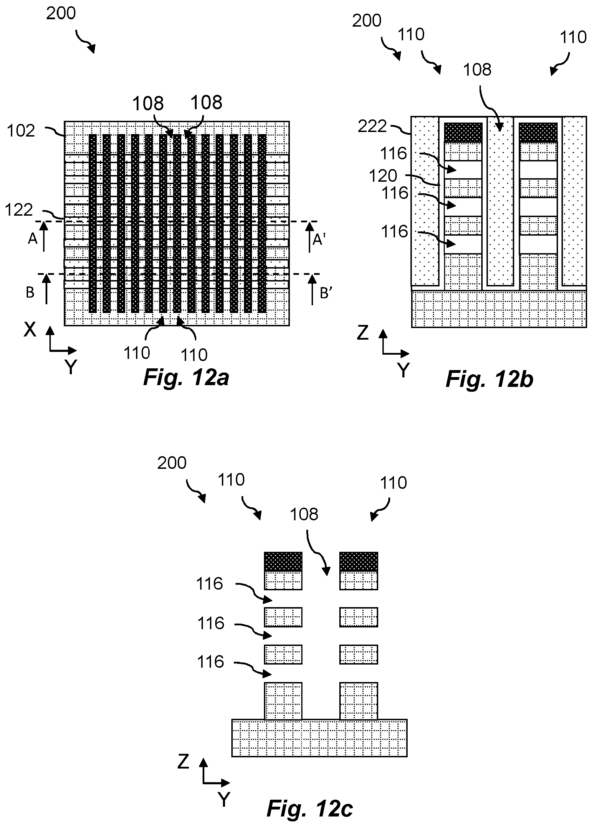

In Figs. 12a-c the sacrificial layers 112 of each fin structure 110 have been removed by a selective etching of the first semiconductor material (i.e. etching the first semiconductor material selectively to the second semiconductor material) from the opposite side surfaces 110s of each fin structure 110, exposed by the anchoring structures. Provided the end surfaces of the fin structures also are exposed by the anchoring structures, the first semiconductor material may also be etched from the exposed end surfaces of the fin structures 110 (c.f. Figs. 7a-b). A longitudinal cavity 116 has thus been formed underneath each channel layer 114 of each fin structure 110. During the removal the channel layers 114 are anchored by the anchoring structures defined by the patterned liner layer 120 and the patterned fill layer 222. An isotropic etching process, wet or dry, may be used to remove the sacrificial layers 112. The mask lines 230 may be removed prior to removing the sacrificial layers 112.

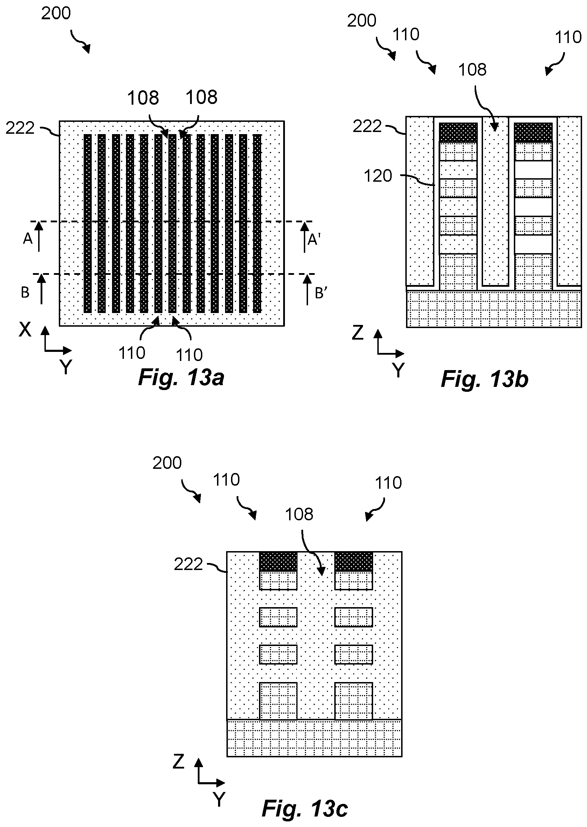

In Figs. 13a-c an insulating material of a same flowable dielectric as the fill layer 222 has been deposited to fill trenches 108 and the cavities 116. As the insulating material is formed of a same material as the fill layer 222, the same reference sign is used to denote the portions of the fill layer 222 forming the anchoring structures and the insulating material filling the trenches 108 and the cavities 116. As mentioned above, the fill layer 222 may in other embodiments be formed by a non-flowable dielectric. However, in such embodiments, the insulating material is still to be formed of a flowable dielectric. In any case, the insulating material 222 may be deposited in the cavities 116 from the sides of the fin structures 110 (and possibly open ends of the cavities 116 at the end surfaces of the fin structures 110). As discussed above in connection with Fig. 8, the deposition of the insulating material 222 may optionally be preceded by a conformal deposition of a further insulating material, such that exposed surfaces of each fin structure 110 (e.g. lower and/or upper surfaces of the channel layers 114 exposed in the cavities 116, and side surfaces of each fin structure 110) are covered by the further insulating material. The further insulating material may for example be a nitride such as SiN, e.g. deposited by ALD. The insulating material 222 may accordingly fill a remaining space of the cavities 116. The conformally deposited layer may mask the semiconductor material of the channel layers 114 from the process conditions during the deposition of the flowable dielectric insulating material 222.

After deposition, the insulating material (i.e. flowable dielectric) 222 may if needed be planarized, e.g. by chemical mechanical polishing (CMP).

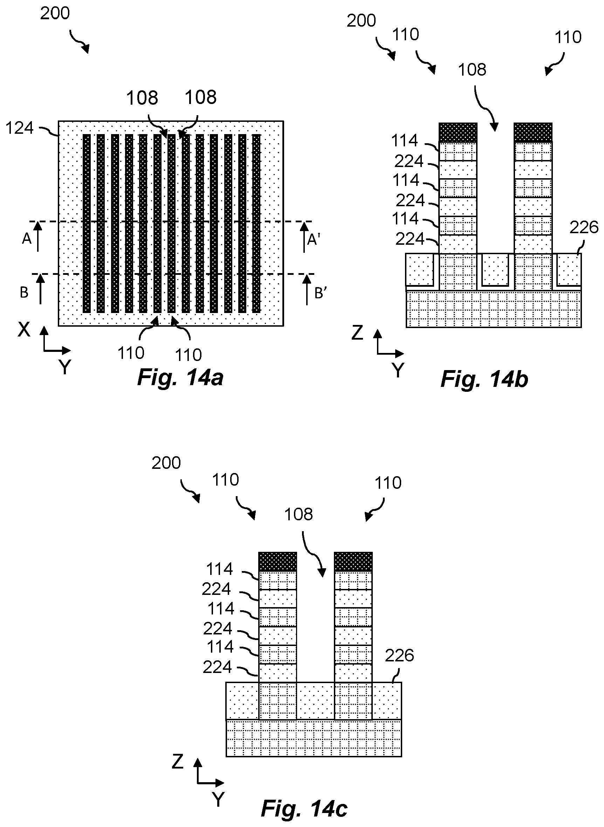

In Figs. 14a-b the anchoring structure / patterned liner layer 120 and the insulating material 222 have been recessed (top-down, e.g. negative Z direction) to a level below a bottom-most one of the cavities 116. As shown, side surfaces of the fin structures 110 may thus exposed and insulating material 222 may remain in the cavities to form insulating layers 224 underneath the channel layers 114. Similar to the description in connection with Figs. 9a-b, the recessing may as shown be stopped such that a thickness portion of the insulating material remains to form STI 226 in a bottom part of the trenches 108. As shown in Fig. 14b, portions of the liner layer 120 may remain on a bottom portion of the fin structures 110 and hence form part of the STI. If the optional conformally deposited further insulating material is present, this may also be recessed to a same extent.

In a further alternative embodiment, a liner layer 120 may be omitted wherein the fill layer 222 may be deposited in contact with the fin structure 110. Hence, a number of anchoring structures may be formed comprising only (i.e. consisting of) a portion of the fill layer 222 preserved underneath a respective mask line 230. The anchoring structures of this alternative embodiment may similar to the embodiment discussed in connection with Figs. 10a-b to 14a-b define "tall" anchoring structures having a thickness / height (e.g. along the Z direction) corresponding to a height of the fin structures 110 above the substrate 102.

In yet another alternative embodiment, a fill layer 222 may be omitted wherein a number of anchoring structures may be formed comprising only (i.e. consisting of) a portion of the liner layer 120 preserved underneath a respective mask line 230.

The resulting semiconductor device structure 100 shown in either of Figs. 9a-b or 14a-c may as discussed be a suitable as precursor for subsequent device fabrication, e.g. a NW- or NSHFET, a forksheet device, or a CFET device.

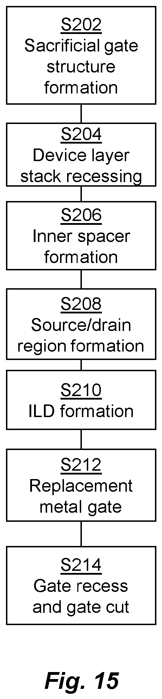

Fig. 15 is a flow chart of an example process flow which may be applied to the fin structures 110 to form a semiconductor device structure comprising a number of horizontal channel transistor structures. The process flow may be varied in a manner which per se is known in the art, e.g. to form horizontal channel devices e.g. of a gate-all-around type or of a forksheet type. It is further possible to adapt the process such that a CFET device comprising e.g. NWSHFET or finFET bottom device and a NSHFET or finFET top device separated by an insulating layer such as layer 124 or 224.

The processing steps may be applied to each of the fin structures 110, or only to a subset of "active" fin structures, wherein the other fin structures may define dummy fin structures.

In step S202 a number of sacrificial gate structures may be formed across the fin structures 110. Each sacrificial gate structure may comprise a sacrificial gate body (e.g. of amorphous Si) and a pair of gate spacers on opposite sides of the sacrificial gate body. The sacrificial gate structures may be formed using conventional processing techniques as per se are known in the art.

In step S204 the fin structures 110 may be recessed (e.g. etched back top-down) using the (respective) sacrificial gate structure as an etch mask, such that portions of insulating layers 124 or 224, and channel layers 114 of each fin structure 110 are preserved underneath the sacrificial gate structure to define a respective device layer stack.

In step S206 inner spacers may be formed at opposite sides of each device layer stack. Inner spacers may be formed in a manner which per se is known in the art of NWFETs/NSHFETs. However, instead of as conventionally done forming recesses by selectively etching a sacrificial semiconductor material (e.g. of SiGe), the recesses may be formed by etching the insulating material of the insulating layers 124, 224. Accordingly, inner spacer cavity formation may proceed by: forming recesses in each device layer stack by an isotropic etching process selective to the insulating material of the insulating layers 124 or 224; a conformal spacer material deposition (e.g. SiN, SiCO deposited by ALD-dielectric); followed by etching of the spacer material such that spacer material remains only in the recesses to form the inner spacers.

In step S208 source/drain regions may be formed on end surfaces of the channel layers 114 of each device layer stack, at opposite sides of the respective sacrificial gate structures. The source/drain regions may for example be formed by selective area Si epitaxy. Techniques such as in-situ doping and/or ion implantation may be used to define n-type and p-type source/drain regions.

In step S210 one or more inter-layer dielectric (ILD) materials may be deposited to cover the device layer stacks, the source/drain regions and the sacrificial gate structures.

In step S212, the sacrificial gate structures may be replaced by functional gates stacks. The replacement may proceed in accordance with a replacement metal gate (RMG) flow. According to an RMG flow, gate trenches are formed by removing the sacrificial gate bodies (e.g. using a selective amorphous Si etch). The RMG flow may proceed by gate dielectric deposition (e.g. high-K dielectric such as HfO2, HfSiO, LaO, AlO or ZrO), gate work function metal deposition and gate (metal) fill deposition.

The process may further comprise a step of channel release, interleaved in the RMG process: That is, subsequent to forming the gate trenches, selectively removing the insulating layers 124 or 224 of each device layer stack by selective etching of the insulating material. Suspended channel layers 114 (e.g. nanosheets) may hence be defined in each gate trench. The functional gate stacks may thus be formed to wrap around the channel layers 114.

Step S212 may be followed by step S214 of recessing the functional gate stacks, and optionally, gate cut formation, as per se is known in the art.

The method may further comprise forming source/drain contacts on the source/drain regions, e.g. by etching contact trenches in the ILD and depositing one of more contact metals therein.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a precursor semiconductor device structure (100), the method comprising:
forming, on a substrate (102), an initial layer stack (104) comprising a sacrificial layer (111) of a first semiconductor material and, over the sacrificial layer (111), a channel layer (113) of a second semiconductor material;
forming a set of fin structures (110) by patterning trenches (108) in the initial layer stack (104), each fin structure (110) comprising a respective sacrificial layer (111) of the first semiconductor material and a respective channel layer (113) of the second semiconductor material;
forming at least one anchoring structure extending across the set of fin structures (110), and while the channel layers (113) are anchored by the at least one anchoring structure:
removing the sacrificial layers (111) of each fin structure (110) by a selective etching of the first semiconductor material, thereby forming a longitudinal cavity (116) underneath the channel layer (113) of each fin structure (110), and
depositing an insulating material to fill the cavities, wherein the insulating material is formed of a flowable dielectric; and
subsequently recessing the at least one anchoring structure and the insulating material to a level below the cavities such that the insulating material remains in the cavities to form insulating layers underneath the channel layers (113) of each fin structure (110);
wherein forming the at least one anchoring structure comprises depositing an anchoring material layer structure of one or more layers on the set of fin structures (110) and in the trenches (108), and patterning the anchoring material layer structure to form the at least one anchoring structure, wherein the anchoring material layer structure comprises an insulating fill layer (222) deposited to fill the trenches (108).

2. A method according to claim 1, wherein patterning the anchoring material layer structure comprises forming at least one mask line extending across the set of fin structures (110) and etching the anchoring material layer structure using the at least one mask line as an etch mask such that fin structure side surface portions not masked by the at least one mask line are exposed,
wherein removing the sacrificial layers (111) comprises etching the first semiconductor material from the exposed side surface portions of each fin structure (110), and
wherein depositing the insulating material comprises depositing the insulating material such that the trenches (108) between the fin structures (110) and the cavities are filled with the insulating material.

3. A method according to claim 1, further comprising forming a fin cut mask over the anchoring material layer structure, wherein patterning the anchoring material layer structure comprises etching the anchoring material layer structure using the fin cut mask as an etch mask, wherein the patterned anchoring material layer structure forms part of the anchoring structure,
wherein the method further comprises, subsequent to patterning the anchoring material layer structure, removing parts of each fin structure (110) by etching the fin structures (110) using the fin cut mask as an etch mask, thereby forming a set of cut fin structures (110) covered by the anchoring structure and having exposed end surfaces,
wherein removing the sacrificial layers (111) comprises etching the first semiconductor material from the exposed end surfaces of each fin structure (110).

4. A method according to claim 2, wherein recessing the at least one anchoring structure and the insulating material comprises simultaneously recessing the insulating fill layer (222) and the insulating material to the level below the cavities, wherein said level is such that a thickness portion of the insulating fill layer (222) and the insulating material remains to form shallow trench isolation in a bottom part of the trenches (108).

5. A method according to claim 3, wherein recessing the anchoring structure and the insulating material comprises simultaneously recessing the insulating fill layer (222) and the insulating material to the level below the cavities, wherein said level is such that a thickness portion of the insulating fill layer (222) remains to form shallow trench isolation in a bottom part of the trenches (108).

6. A method according to any one of claims 4-5, wherein the insulating fill layer (222) is formed of a same material as the insulating material.

7. A method according to any one of the preceding claims, wherein the anchoring material layer structure comprises an insulating liner layer conformally deposited on the fin structures (110) and in the trenches (108).

8. A method according to claim 7, wherein the insulating fill layer (222) is deposited on the liner layer.

9. A method according to any one of claims 7-8, wherein recessing the at least one anchoring structure further comprises removing portions of the liner layer present above said level by etching.

10. A method according to any one of the preceding claims, wherein the insulating material is a flowable oxide.

11. A method according to any of the preceding claims, wherein the channel layer (113) is a second channel layer and the initial layer stack (104) and each fin structure (110) comprises a first channel layer of the second semiconductor material, wherein the sacrificial layer (111) is formed on the first channel layer and the second channel layer is formed on the sacrificial layer (111).

12. A method according to claim 11, wherein the sacrificial layer (111) is a second sacrificial layer and the initial layer stack (104) and each fin structure (110) comprises a first sacrificial layer of the first semiconductor material, wherein the first channel layer is formed on the first sacrificial layer.

13. A method for forming a semiconductor device, the method comprising:
forming a precursor semiconductor device structure (100) in accordance with any one of the preceding claims; and
along one or more of the fin structures (110), forming a gate structure and source and drain regions.

## Patentansprüche

1. Verfahren zum Bilden einer Vorläufer-Halbleiterbauelementstruktur (100), wobei das Verfahren umfasst:
Bilden, auf einem Substrat (102), eines anfänglichen Schichtstapels (104), der eine Opferschicht (111) aus einem ersten Halbleitermaterial und über der Opferschicht (111) eine Kanalschicht (113) aus einem zweiten Halbleitermaterial umfasst;
Bilden einer Menge von Finnenstrukturen (110) durch Strukturieren von Gräben (108) in dem anfänglichen Schichtstapel (104), wobei jede Finnenstruktur (110) eine jeweilige Opferschicht (111) aus dem ersten Halbleitermaterial und eine jeweilige Kanalschicht (113) aus dem zweiten Halbleitermaterial umfasst;
Bilden mindestens einer Verankerungsstruktur, die sich über die Menge von Finnenstrukturen (110) erstreckt, und während die Kanalschichten (113) durch die mindestens eine Verankerungsstruktur verankert werden:
Entfernen der Opferschichten (111) jeder Finnenstruktur (110) durch selektives Ätzen des ersten Halbleitermaterials, wodurch ein länglicher Hohlraum (116) unterhalb der Kanalschicht (113) jeder Finnenstruktur (110) gebildet wird; und
Abscheiden eines Isoliermaterials, um die Hohlräume auszufüllen, wobei das Isoliermaterial aus einem fließfähigen Dielektrikum gebildet wird; und
anschließend Vertiefen der mindestens einen Verankerungsstruktur und des Isoliermaterials bis auf ein Niveau unterhalb der Hohlräume, so dass das Isoliermaterial in den Hohlräumen bleibt, um unterhalb der Kanalschichten (113) jeder Finnenstruktur (110) Isolierschichten zu bilden;
wobei das Bilden der mindestens einen Verankerungsstruktur das Abscheiden einer Struktur einer Verankerungsmaterialschicht aus einer oder mehreren Schichten auf der Menge von Finnenstrukturen (110) und in den Gräben (108) und das Strukturieren der Verankerungsmaterialschichtstruktur, um die mindestens eine Verankerungsstruktur zu bilden, umfasst, wobei die Verankerungsmaterialschichtstruktur eine isolierende Füllschicht (222) umfasst, die abgeschieden wird, um die Gräben (108) auszufüllen.

2. Verfahren nach Anspruch 1, wobei das Strukturieren der Verankerungsmaterialschichtstruktur das Bilden mindestens einer Maskenlinie, die sich über die Menge von Finnenstrukturen (110) erstreckt, und das :Atzen der Verankerungsmaterialschichtstruktur unter Verwendung der mindestens einen Maskenlinie als Ätzmaske, so dass Seitenflächenabschnitte der Finnenstruktur, die nicht von der mindestens einen Maskenlinie maskiert sind, freigelegt werden, umfasst,
wobei das Entfernen der Opferschichten (111) das Ätzen des ersten Halbleitermaterials von den freigelegten Seitenflächenabschnitten jeder Finnenstruktur (110) umfasst, und
wobei das Abscheiden des Isoliermaterials das Abscheiden des Isoliermaterials umfasst, so dass die Gräben (108) zwischen den Finnenstrukturen (110) und den Hohlräumen mit dem Isoliermaterial ausgefüllt werden.

3. Verfahren nach Anspruch 1, ferner umfassend das Bilden einer Finnenschneidemaske über der Verankerungsmaterialschichtstruktur, wobei das Strukturieren der Verankerungsmaterialschichtstruktur das Ätzen der Verankerungsmaterialschichtstruktur unter Verwendung der Finnenschneidemaske als Ätzmaske umfasst, wobei die strukturierte Verankerungsmaterialschichtstruktur Teil der Verankerungsstruktur ist,
wobei das Verfahren ferner, nach dem Strukturieren der Verankerungsmaterialschichtstruktur, das Entfernen von Teilen jeder Finnenstruktur (110) durch Ätzen der Finnenstrukturen (110) unter Verwendung der Finnenschneidemaske als Ätzmaske umfasst, wodurch eine Menge von ausgeschnittenen Finnenstrukturen (110) gebildet wird, die von der Verankerungsstruktur bedeckt ist und freigelegte Endflächen aufweist,
wobei das Entfernen der Opferschichten (111) das Ätzen des ersten Halbleitermaterials von den freigelegten Endflächen jeder Finnenstruktur (110) umfasst.

4. Verfahren nach Anspruch 2, wobei das Vertiefen der mindestens einen Verankerungsstruktur und des Isoliermaterials das gleichzeitige Vertiefen der Isolierfüllschicht (222) und des Isoliermaterials bis auf das Niveau unterhalb der Hohlräume umfasst, wobei das Niveau derart ist, dass ein Dickenabschnitt der Isolierfüllschicht (222) und des Isoliermaterials zurückbleibt, um eine seichte Grabenisolierung in einem unteren Teil der Gräben (108) zu bilden.

5. Verfahren nach Anspruch 3, wobei das Vertiefen der Verankerungsstruktur und des Isoliermaterials das gleichzeitige Vertiefen der Isolierfüllschicht (222) und des Isoliermaterials bis auf das Niveau unterhalb der Hohlräume umfasst, wobei das Niveau derart ist, dass ein Dickenabschnitt der Isolierfüllschicht (222) zurückbleibt, um eine seichte Grabenisolierung in einem unteren Teil der Gräben (108) zu bilden.

6. Verfahren nach einem der Ansprüche 4 bis 5, wobei die Isolierfüllschicht (222) aus dem gleichen Material wie das Isoliermaterial gebildet wird.

7. Verfahren nach einem der vorhergehenden Ansprüche, wobei die Verankerungsmaterialschichtstruktur eine isolierende Auskleidungsschicht umfasst, die konform auf den Finnenstrukturen (110) und in den Gräben (108) abgeschieden wird.

8. Verfahren nach Anspruch 7, wobei die Isolierfüllschicht (222) auf der Auskleidungsschicht abgeschieden wird.

9. Verfahren nach einem der Ansprüche 7 bis 8, wobei das Vertiefen der mindestens einen Verankerungsstruktur ferner das Entfernen durch Ätzen von Abschnitten der Auskleidungsschicht, die oberhalb des Niveaus vorhanden sind, umfasst.

10. Verfahren nach einem der vorhergehenden Ansprüche, wobei das Isoliermaterial ein fließfähiges Oxid ist.

11. Verfahren nach einem der vorhergehenden Ansprüche, wobei die Kanalschicht (113) eine zweite Kanalschicht ist, und der anfängliche Schichtstapel (104) und jede Finnenstruktur (110) eine erste Kanalschicht aus dem zweiten Halbleitermaterial umfassen, wobei die Opferschicht (111) auf der ersten Kanalschicht gebildet wird, und die zweite Kanalschicht auf der Opferschicht (111) gebildet wird.

12. Verfahren nach Anspruch 11, wobei die Opferschicht (111) eine zweite Opferschicht ist, und der anfängliche Schichtstapel (104) und jede Finnenstruktur (110) eine erste Opferschicht aus dem ersten Halbleitermaterial umfassen, wobei die erste Kanalschicht auf der ersten Opferschicht gebildet wird.

13. Verfahren zum Bilden eines Halbleiterbauelements, wobei das Verfahren umfasst:
Bilden einer Vorläufer-Halbleiterbauelementstruktur (100) nach einem der vorhergehenden Ansprüche; und
entlang einer oder mehrerer der Finnenstrukturen (110), Bilden einer Gate-Struktur und von Source- und Drain-Regionen.

## Revendications

1. Procédé de formation d'une structure de dispositif semi-conducteur précurseur (100), le procédé comprenant :
la formation, sur un substrat (102), d'une pile de couches initiale (104) comprenant une couche sacrificielle (111) d'un premier matériau semi-conducteur et, sur la couche sacrificielle (111), une couche de canal (113) d'un deuxième matériau semi-conducteur ;
la formation d'un ensemble de structures à ailettes (110) par structuration de tranchées (108) dans la pile de couches initiale (104), chaque structure à ailette (110) comprenant une couche sacrificielle respective (111) du premier matériau semi-conducteur et une couche de canal respective (113) du deuxième matériau semi-conducteur ;
la formation d'au moins une structure d'ancrage s'étendant à travers l'ensemble des structures d'ailettes (110), et tandis que les couches de canal (113) sont ancrées par la au moins une structure d'ancrage :
l'élimination des couches sacrificielles (111) de chaque structure d'ailette (110) par une gravure sélective du premier matériau semi-conducteur, en formant ainsi une cavité longitudinale (116) sous la couche de canal (113) de chaque structure d'ailette (110) et
le dépôt d'un matériau isolant pour remplir les cavités, dans lequel le matériau isolant est formé d'un diélectrique fluide ; et
l'encastrement ultérieur d'au moins une structure d'ancrage et du matériau isolant à un niveau inférieur aux cavités de sorte que le matériau isolant reste dans les cavités pour former des couches isolantes sous les couches de canal (113) de chaque structure d'ailette (110) ;
dans lequel la formation d'au moins une structure d'ancrage comprend le dépôt d'une structure de couche de matériau d'ancrage composée d'une ou plusieurs couches sur l'ensemble de structures d'ailettes (110) et dans les tranchées (108) et la structuration de la structure de couche de matériau d'ancrage pour former au moins une structure d'ancrage, dans lequel la structure de couche de matériau d'ancrage comprend une couche de remplissage isolante (222) déposée pour remplir les tranchées (108).

2. Procédé selon la revendication 1, dans lequel la structuration de la structure de couche de matériau d'ancrage comprend la formation d'au moins une ligne de masque s'étendant à travers l'ensemble de structures d'ailettes (110) et la gravure de la structure de couche de matériau d'ancrage en utilisant la au moins une ligne de masque comme masque de gravure, de sorte que les parties de surface latérales des structures d'ailettes non masquées par la au moins une ligne de masque soient exposées ;
dans lequel l'élimination des couches sacrificielles (111) comprend la gravure du premier matériau semi-conducteur des parties de surface latérales exposées de chaque structure d'ailette (110) ; et
dans lequel le dépôt du matériau isolant comprend le dépôt du matériau isolant de sorte que les tranchées (108) entre les structures d'ailettes (110) et les cavités soient remplies de matériau isolant.

3. Procédé selon la revendication 1, comprenant en outre la formation d'un masque de découpe d'ailettes sur la structure de couche de matériau d'ancrage, dans lequel la structuration de la structure de couche de matériau d'ancrage comprend la gravure de la structure de couche de matériau d'ancrage en utilisant le masque de découpe d'ailettes comme masque de gravure, dans lequel la structure de couche de matériau d'ancrage structurée fait partie de la structure d'ancrage,
dans lequel le procédé comprend en outre, après la structuration de la structure de couche de matériau d'ancrage, l'élimination de parties de chaque structure d'ailette (110) par gravure des structures d'ailettes (110) en utilisant le masque de découpe d'ailettes comme masque de gravure, en formant ainsi un ensemble de structures de découpe d'ailettes (110) recouvertes par la structure d'ancrage et présentant des surfaces d'extrémité exposées,
dans lequel l'élimination des couches sacrificielles (111) comprend la gravure du premier matériau semi-conducteur des surfaces d'extrémité exposées de chaque structure d'ailette (110).

4. Procédé selon la revendication 2, dans lequel l'encastrement d'au moins une structure d'ancrage et du matériau isolant comprend simultanément :
l'encastrement de la couche de remplissage isolante (222) et du matériau isolant jusqu'au niveau inférieur aux cavités, dans lequel ledit niveau est tel qu'une partie de l'épaisseur de la couche de remplissage isolante (222) et du matériau isolant subsiste pour former une isolation par tranchée peu profonde dans une partie inférieure des tranchées (108).

5. Procédé selon la revendication 3, dans lequel l'encastrement de la structure d'ancrage et du matériau isolant comprend simultanément l'encastrement de la couche de remplissage isolante (222) et du matériau isolant jusqu'au niveau inférieur aux cavités, dans lequel ledit niveau est tel qu'une partie de l'épaisseur de la couche de remplissage isolante (222) subsiste pour former une isolation par tranchée peu profonde dans une partie inférieure des tranchées (108).

6. Procédé selon une quelconque des revendications 4 à 5, dans lequel la couche de remplissage isolante (222) est constituée d'un même matériau que le matériau isolant.

7. Procédé selon une quelconque des revendications précédentes, dans lequel la structure de couche de matériau d'ancrage comprend une couche de revêtement isolante déposée de manière conforme sur les structures d'ailettes (110) et dans les tranchées (108).

8. Procédé selon la revendication 7, dans lequel la couche de remplissage isolante (222) est déposée sur la couche de revêtement.

9. Procédé selon une quelconque des revendications 7 et 8, dans lequel l'encastrement d'au moins une structure d'ancrage comprend en outre l'élimination de parties de la couche de revêtement présente au-dessus dudit niveau par gravure.

10. Procédé selon une quelconque des revendications précédentes, dans lequel le matériau isolant est un oxyde fluide.

11. Procédé selon une quelconque des revendications précédentes, dans lequel la couche de canal (113) est une deuxième couche de canal et la pile de couches initiale (104) et chaque structure d'ailette (110) comprend une première couche de canal du deuxième matériau semi-conducteur, dans lequel la couche sacrificielle (111) est formée sur la première couche de canal et la deuxième couche de canal est formée sur la couche sacrificielle (111).

12. Procédé selon la revendication 11, dans lequel la couche sacrificielle (111) est une deuxième couche sacrificielle et la pile de couches initiale (104) et chaque structure d'ailette (110) comprend une première couche sacrificielle du premier matériau semi-conducteur, dans lequel la première couche de canal est formée sur la première couche sacrificielle.

13. Procédé de fabrication d'un dispositif semi-conducteur, comprenant :
la formation d'une structure de dispositif semi-conducteur précurseur (100) conformément à une quelconque des revendications précédentes ; et
le long d'une ou plusieurs structures à ailettes (110), la formation d'une structure de grille et de régions de source et de drain.
